# EUROPEAN PATENT APPLICATION

(11) **EP 2 017 672 A2**
(43) Date of publication of application: **21.01.2009**
(21) Application number: 08160676.6
(22) Date of filing: 18.07.2008
(51) Int. Cl.: G03F 1/14

(54) **Pellicle frame**

(30) Priority: 19.07.2007 JP 2007188715
(71) Applicant: Shin-Etsu Chemical Co., Ltd., Tokyo (JP)
(72) Inventor: Shirasaki, Toru, Annaka-shi, Gunma-ken (JP)
(74) Representative: Peaucelle, Chantal

(57) **Abstract**

The present invention is directed to provide a pellicle that can control the deformation of the photomask to a minimum without particular consideration of the flatness of a pellicle frame even in the case where a pellicle is affixed to a photomask for lithography. In the pellicle of the present invention, a cross-sectional area of a pellicle frame is 6 mm² or less. In the pellicle of the present invention, a pellicle frame is made of a material having a Young's modulus of 50 GPa or less.

## Description

### BACKGROUND OF THE INVENTION

### 1. Field of the Invention

The present invention relates to a lithographic pellicle, in particular to a lithographic pellicle used as dust-proof protection in the manufacture of semiconductor devices such as LSI or ultra-LSI. More particularly, the invention relates to a lithographic pellicle frame used for ultraviolet exposure light of 200 nm or shorter wavelength used for patterning light exposure which requires high resolution.

### 2. Description of the Related Art

Conventionally, the manufacture of semiconductor devices such as LSI and ultra-LSI, or liquid crystal display panels and the like, has involved employing procedures such as lithography for the patterning of semiconductor wafers or liquid crystal original plates through irradiation of light. However, there is a problem that any dust adhering to the employed original plate absorbs and reflects light, which deforms and roughens the edges of the replicated patterning, thereby detracting from dimensions, quality, and appearance, and impairing the performance of the semiconductor device and/or liquid crystal display panel, while reducing the manufacturing yield thereof.

Thus, these operations are ordinarily carried out in clean rooms, but keeping exposure original plates clean at all times in such clean rooms is difficult, and hence pellicles having good light transmissivity are adhered, as dust-proof protection, to the surface of exposure original plates. The advantage of the pellicle is that dust does not attach directly to the surface of the exposure original plate, but becomes adhered to the pellicle membrane, so that if focus is in accord with the pattern of the exposure original plate during lithography, transfer is not affected by dust on the pellicle.

The pellicle is made up of a pellicle frame comprising aluminum, stainless steel, polyethylene or the like, a transparent pellicle membrane adhered on the upper surface of the pellicle frame, comprising nitrocellulose, cellulose acetate or the like having good light transmissivity, an adhesive layer coated on the lower surface of the pellicle frame, and a release layer (separator) adhered on the adhesive layer. The adhesive bonding between the pellicle frame and pellicle membrane is carried out by coating a good solvent for the pellicle membrane material and then air-drying the solvent (Japanese Patent Application Laid-open No. S58-219023) or using an adhesive agent such as an acrylic resin, epoxy resin or the like (US Patent No. 4861402, Japanese Patent Examined Application Publication No. S63-27707, Japanese Unexamined Patent Application Laid-open No. H07-168345).

As a result of ever higher lithography resolutions encountered in recent years, the employed light sources are gradually shifting to shorter wavelengths in order to realize such resolutions. Specifically, there has been a shift towards g-line (436 nm), i-line (365 nm), KrF excimer lasers (248 nm) in ultraviolet light, while ArF excimer lasers (193 nm) have begun to be used recently.

### SUMMARY OF THE INVENTION

In a semiconductor exposure device, the pattern drawn on a photomask is burned onto a silicon wafer by way of short-wavelength light. Irregularities on the photomask and the silicon wafer give rise however to focal shift, which impairs the pattern printed onto the wafer. The required flatness from photomasks and silicon wafers is getting more stringent as the patterning becomes finer and finer. For instance, the required flatness from photomasks is becoming gradually more demanding, from a flatness of 2 µm at the pattern plane, down to 0.5 µm and 0.25 µm for the 65 nm node and beyond.

Pellicles are affixed onto finished photomasks as dust-proof protection of the latter. However, the flatness of a photomask may change upon affixing of a pellicle on the photomask. Deficient photomask flatness can give rise to problems such as the above-described focal shift. Changes in flatness alter the shape of the pattern drawn on the photomask and give rise also to problems as regards focal displacement on the photomask.

In contrast, photomask flatness may be improved by pellicle affixing. Although in this case focal shift is not a problem, pattern shape changes still give rise to problems as regards focal displacement on the photomask. In leading-art photomasks, thus, photomask flatness must not change when a pellicle is affixed. However, photomask flatness often changes when a pellicle is affixed thereto. There are several factors that give rise to photomask flatness changes upon affixing of a pellicle, but the most relevant, as is uncoverd by the inventor, is the flatness of the pellicle frame.

Conventional pellicle frames generally are made of aluminum alloy. Pellicle frames, the size of which is usually determined by the specifications for exposure devices, have a width of about 150 mm, a length of about 110 to 130 mm and a thickness of about 2 mm, and have a shape with an opening in a central region. Generally, pellicle frames are manufactured by cutting a plate of aluminum alloy into the pellicle frame shape, or extrusion molding of aluminum alloy material into the pellicle frame shape.

The flatness of the pellicle frame ranges ordinarily from about 20 to 80 µm. When a pellicle using a frame having such substantial flatness is affixed onto a photomask, however, the shape of the frame becomes transferred to the photomask, deforming the latter. During affixing onto the photomask, the pellicle is pressed against the photomask with a substantial force, of about 196.1 to 392.2 N (20 to 40 kgf). Herein, a photomask surface having a flatness no greater than several µm is flatter than the frame, and hence the frame is assumed to undergo elastic deformation to a flat state when pressed against the photomask.
The frame tends to revert back to its original shape when pressing is over, but since it is bonded to the photomask surface, the photomask deforms as well consequently.

Therefore, investigations are being done to reduce the deformation of the photomask during the pellicle affixation by improving the flatness of the pellicle frame to reduce the deformation of the pellicle frame; but in the case of a pellicle frame made of aluminum alloy, it is difficult to manufacture a pellicle frame having good flatness.

In consideration of circumstances such as those recited above, the present invention is directed to prevent the occurrence of distortion of the photomask even in the case where the pellicle is affixed to the photomask.

The inventor completed the present invention by discovering a solution to the problem recited above by keeping the cross-sectional area of the pellicle frame within 6 mm² or less, or manufacturing the aluminum pellicle frame from a material having a Young's modulus of 50 GPa or less. In other words, the present invention comprises a pellicle used in semiconductor lithography, characterized in that a cross-sectional area of a pellicle frame is 6 mm² or less. Furthermore, the pellicle used in semiconductor lithography is characterized in that a pellicle frame is made of a material having a Young's modulus of 50 GPa or less.

An excellent pellicle frame can be provided that enables reduction of the deformation of the pellicle frame and reduction of the deformation of the photomask during the pellicle affixation by improving the flatness of the pellicle frame.

### DESCRIPTIUON OF PREFERRED EMBODIMENTS

As recited above, the distortion of the pellicle frame occurring during the pellicle affixation is thought to be one cause of the distortion of the photomask due to the pellicle affixation. The pellicle frame deforms during affixation and attempts to return to its original shape; the resulting deformation stress causes deformation of the photomask. The deformation stress is dependent on the cross-sectional area of the pellicle frame, the Young's modulus of the material from which it is formed, and the deformation amount. Therefore, even in the case where the deformation amount is unchanged, a smaller cross-sectional area of the pellicle frame or a smaller Young's modulus of the material causes a correspondingly smaller deformation stress, thereby resulting in a smaller deformation of the photomask.

Pellicle frames generally being used currently have a width of about 2 mm and a height of 4 to 6.3 mm; excluding the height of an adhesive, the pellicle frames have a height of 3.5 to 5.8 mm. A cross-sectional area of such a configuration is about 7 mm² to 11.6 mm². Here, reducing the cross-sectional area of the pellicle frame to 6 mm² or less enables a reduction of the deformation stress. In such a case, a pellicle frame having an unchanged width of 2 mm would correspond to a height of 3 mm or less. Likewise, in the case where a pellicle has a height of 6 mm, the width may be 1 mm.

Furthermore, pellicle frames generally are made of aluminum alloy having a Young's modulus of about 70 GPa, but using a material having a smaller Young's modulus, in particular a material of 50 GPa or less, can enable a similar reduction of the deformation stress. Examples of materials having Young's modulus of 50 GPa or less include magnesium alloy at 44 GPa, acrylic resin at 3 GPa, and polycarbonate resin at 2.5 GPa.

### EXAMPLES

Hereinafter, the present invention is described specifically by examples, but the present invention is not limited to the following examples.

### Example 1

A 5% solution of Cytop CTX-S [name of product manufactured by Asahi Glass Co., Ltd.] dissolved in perfluorotributylamine was dropped onto a silicon wafer and spread on the wafer by spin coating, rotating the wafer at 830 rpm. Then, drying was performed at room temperature for 30 minutes, after which further drying was performed at 180°C, thus forming a uniform film. An aluminum frame applied with a bonding agent was affixed thereupon, and only the film was peeled off, thus forming a pellicle film.

A pellicle frame was manufactured of aluminum alloy with outer dimensions of 149 mm x 122 mm x 3 mm, and a width of 2 mm (cross-sectional area of 6 mm²). The flatness of the pellicle frame as measured on a side to be applied with the photomask adhesive was 50µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The completed pellicle was affixed by a load of 20 kgf to a 142 mm square photomask having a flatness of 0.4µm. Then, measurement of the flatness of the photomask, now with the pellicle attached, showed a value of 0.55µm; the change in the flatness was 0.15µm, and thus a small value was achieved as compared to that of the Comparative Example. The flatness measurement results are summarized in Table 1. Furthermore, affixing a pellicle to a photomask may cause a macroscopic unevenness of the photomask: for example, convexities at the four corners and a concavity at the center may be visible to the naked eye; but regarding this aspect as well, it was found that the present invention enables improvement of the shape of the photomask.

### Example 2

A 5% solution of Cytop CTX-S [aforementioned] dissolved in perfluorotributylamine was dropped onto a silicon wafer and spread on the wafer by spin coating, rotating the wafer at 830 rpm. Then, drying was performed at room temperature for 30 minutes, after which drying was performed at 180°C, thus forming a uniform film. An aluminum frame applied with a bonding agent was affixed thereupon, and only the film was peeled off, thus forming a pellicle film.

A pellicle frame was manufactured of aluminum alloy with outer dimensions of 149 mm x 122 mm x 2.5 mm, and a width of 1.6 mm (cross-sectional area of 4 mm²). The flatness of the pellicle frame as measured on a side to be applied with the photomask adhesive was 50 µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The completed pellicle was affixed by a load of 20 kgf to a 142 mm square photomask having a flatness of 0.4 µm. Then, measurement of the flatness of the photomask, now with the pellicle attached, showed a value of 0.5 µm; the change in flatness was 0.1 µm, and thus a very small value was achieved as compared to that of the Comparative Example. The flatness measurement results are summarized in Table 1. Furthermore, regarding the shape of the photomask as well, no large change detectable by the naked eye had occurred.

### Example 3

A 5% solution of Cytop CTX-S [aforementioned] dissolved in perfluorotributylamine was dropped onto a silicon wafer and spread on the wafer by spin coating, rotating the wafer at 830 rpm. Then, drying was performed at room temperature for 30 minutes, after which drying was performed at 180°C, thus forming a uniform film. An aluminum frame applied with a bonding agent was affixed thereupon, and only the film was peeled off, thus forming a pellicle film.

A pellicle frame was manufactured of magnesium alloy with outer dimensions of 149 mm x 122 mm x 2.5 mm, and a width of 2 mm (cross-sectional area of 11.6 mm²). The flatness of the pellicle frame as measured on a side to be applied with the photomask adhesive was 50 µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The completed pellicle was affixed by a load of 20 kgf to a 142 mm square photomask having a flatness of 0.4 µm. Then, measurement of the flatness of the photomask, now with the pellicle attached, showed a value of 0.48µm; the change in flatness was 0.08 µm, and thus a very small value was achieved. The flatness measurement results are summarized in Table 1. Furthermore, regarding the shape of the photomask as well, no large change detectable by the naked eye had occurred.

### Example 4

A 5% solution of Cytop CTX-S [aforementioned] dissolved in perfluorotributylamine was dropped onto a silicon wafer and spread on the wafer by spin coating, rotating the wafer at 830 rpm. Then, drying was performed at room temperature for 30 minutes, after which drying was performed at 180°C, thus forming a uniform film. An aluminum frame applied with a bonding agent was affixed thereupon, and only the film was peeled off, thus forming a pellicle film.

A pellicle frame was manufactured of magnesium alloy with outer dimensions of 149 mm x 122 mm x 2.5 mm, and a width of 2 mm (cross-sectional area of 5 mm²). The flatness of the pellicle frame as measured on a side to be applied with the photomask adhesive was 50 µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The completed pellicle was affixed by a load of 20 kgf to a 142 mm square photomask having a flatness of 0.4µm. Then, measurement of the flatness of the photomask, now with the pellicle attached, showed a value of 0.44µm; the change in flatness was 0.04 µm, and thus a very small value was achieved. The flatness measurement results are summarized in Table 1. Furthermore, regarding the shape of the photomask as well, no large change detectable by the naked eye had occurred.

### Example 5

A 5% solution of Cytop CTX-S [aforementioned] dissolved in perfluorotributylamine was dropped onto a silicon wafer and spread on the wafer by spin coating, rotating the wafer at 830 rpm. Then, drying was performed at room temperature for 30 minutes, after which drying was performed at 180°C, thus forming a uniform film. An aluminum frame applied with a bonding agent was affixed thereupon, and only the film was peeled off, thus forming a pellicle film.

A pellicle frame was manufactured of a polycarbonate with outer dimensions of 149 mm x 122 mm x 2.5 mm, and a width of 2 mm (cross-sectional area of 11.6 mm²). The flatness of the pellicle frame as measured on a side to be applied with the photomask adhesive was 50 µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The completed pellicle was affixed by a load of 20 kgf to a 142 mm square photomask having a flatness of 0.4µm. Then, measurement of the flatness of the photomask, now with the pellicle attached, showed a value of 0.42µm; the change in flatness was 0.02 µm, and thus a very small value was achieved. The flatness measurement results are summarized in Table 1. Furthermore, regarding the shape of the photomask as well, no large change detectable by the naked eye had occurred.

### Example 6

A 5% solution of Cytop CTX-S [aforementioned] dissolved in perfluorotributylamine was dropped onto a silicon wafer and spread on the wafer by spin coating, rotating the wafer at 830 rpm. Then, drying was performed at room temperature for 30 minutes, after which drying was performed at 180°C, thus forming a uniform film. An aluminum frame applied with a bonding agent was affixed thereupon, and only the film was peeled off, thus forming a pellicle film.

A pellicle frame was manufactured of a polycarbonate with outer dimensions of 149 mm x 122 mm x 2.5 mm, and a width of 2 mm (cross-sectional area of 5 mm²). The flatness of the pellicle frame as measured on a side to be applied with the photomask adhesive was 50µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle.

The completed pellicle was affixed by a load of 20 kgf to a 142 mm square photomask having a flatness of 0.4µm. Then, measurement of the flatness of the photomask, now with the pellicle attached, showed a value of 0.41µm; and thus there was little change in flatness. The flatness measurement results are summarized in Table 1.
Furthermore, regarding the shape of the photomask as well, no large change detectable by the naked eye had occurred.

### Comparative Example 1

A 5% solution of Cytop CTX-S [aforementioned] dissolved in perfluorotributylamine was dropped onto a silicon wafer and spread on the wafer by spin coating, rotating the wafer at 830 rpm. Then, drying was performed at room temperature for 30 minutes, after which drying was performed at 180°C, thus forming a uniform film. An aluminum frame applied with a bonding agent was affixed thereupon, and only the film was peeled off, thus forming a pellicle film.

A pellicle frame was manufactured of aluminum alloy with outer dimensions of 149 mm x 122 mm x 5.8 mm, and a width of 2 mm (cross-sectional area of 11.6 mm²). The flatness of the pellicle frame as measured on a side to be applied with the photomask adhesive was 50 µm. One end face of the pellicle frame was applied with the photomask adhesive, and another end face was applied with a film bonding agent. Then, the previously peeled-off pellicle film was affixed to the film bonding agent side of the aluminum frame, and the film of the outer circumference of the pellicle frame was trimmed, thus completing the pellicle. The completed pellicle was affixed by a load of 20 kgf to a 142 mm square photomask having a flatness of 0.4µm. Then, measurement of the flatness of the photomask, now with the pellicle attached, showed a value of 0.7µm; the change in flatness was no less than 0.3µm.
Furthermore, regarding the shape of the photomask as well, the significant change detectable by the naked eye had occurred.

**Table 1 - Flatness measurement results**

| | Material Young's modulus | cross-sectional area (mm²) | Photomask flatness( µm) | | |
|---|---|---|---|---|---|
| | | | Before affixing | After affixing | Deformation |
| Example 1 | aluminum alloy 69GPa | 6 | 0.4 | 0.55 | + 0.15 |
| Example 2 | | 4 | 0.4 | 0.46 | + 0.1 |
| Example 3 | magnesium alloy 44GPa | 11.6 | 0.4 | 0.48 | + 0.08 |
| Example 4 | | 5 | 0.4 | 0.44 | + 0.04 |
| Example 5 | polycarbonate 2.5GPa | 11.6 | 0.4 | 0.42 | + 0.02 |
| Example 6 | | 5 | 0.4 | 0.41 | +0.01 |
| Comparative Example 1 | aluminum alloy 69GPa | 11.6 | 0.4 | 0.7 | + 0.3 |

An excellent pellicle frame can be provided that enables reduction of the deformation of the pellicle frame and thereby reduction of the deformation of the photomask during pellicle affixation by improving the flatness of the pellicle frame; and therefore, the industrial utility value is quite high in fields using semiconductor lithography.

## Claims

1. A pellicle used in semiconductor lithography, **characterized in that** a cross-sectional area of a pellicle frame is 6 mm² or less.

2. A pellicle used in semiconductor lithography, **characterized in that** a pellicle frame is made of a material having a Young's modulus of 50 GPa or less.
